Europäisches Patentamt

European Patent Office

Office européen des brevets

(19)

(11) Veröffentlichungsnummer: **0 244 605 B1**

(12) **EUROPÄISCHE PATENTSCHRIFT**

(45) Veröffentlichungstag der Patentschrift: **11.09.91**

(51) Int. Cl.⁵: **H03K 19/177**

(21) Anmeldenummer: **87103962.4**

(22) Anmeldetag: **18.03.87**

(54) **In integrierter Technik hergestellter Logik-Array-Baustein zur Erstellung integrierter Schaltungen.**

(30) Priorität: **07.04.86 DE 3611557**

(43) Veröffentlichungstag der Anmeldung:
**11.11.87 Patentblatt 87/46**

(45) Bekanntmachung des Hinweises auf die
Patenterteilung:
**11.09.91 Patentblatt 91/37**

(84) Benannte Vertragsstaaten:
**DE FR GB IT SE**

(56) Entgegenhaltungen:
**DE-A- 2 826 722**

**ELECTRONICS LETTERS, Band 21, Nr. 20, 26.
September 1985, Seiten 891-892, Stevenage,
Herts, GB; W. BROCKMANN et al.: "New logic
array concept with high flexibility"**

(73) Patentinhaber: **Siemens Nixdorf Informationssysteme Aktiengesellschaft
Fürstenallee 7
W-4790 Paderborn(DE)**

(72) Erfinder: **Brockmann, Werner
Burgstrasse 8
W-4791 Altenbeken(DE)**

(74) Vertreter: **Schaumburg, Thoenes & Englaender
Mauerkircherstrasse 31 Postfach 86 07 48
W-8000 München 86(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen in integrierter Technik hergestellten Baustein zur Erstellung integrierter Schaltungen gemäß dem Oberbegriff des Anspruchs 1.

Bausteine mit Verknüpfungsfeldern oder Logik-Arrays zur Darstellung logischer Schaltungen sind in vielfältigen Ausführungsformen, insbesondere mit programmierbaren Kopplungselementen bekannt. Eine Programmierung kann mit Hilfe von Masken bei der Herstellung des Bausteines oder auch nachträglich beispielsweise durch die Bearbeitung des Bausteines mittels eines Laserstrahles, aber vorzugsweise auf elektrischem Wege erfolgen. Die Array-Struktur der Verknüpfungsfelder bietet den Vorteil, daß in ihnen alle denkbaren booleschen Verknüpfungen der Eingangsgrößen untereinander und gegebenenfalls mit zurückgeführten Signalen vorgenommen werden können. Die Programmierbarkeit erlaubt dabei die Anpassung der integrierten Schaltung an die jeweilige Aufgabe, nachdem die integrierte Schaltung vollständig (bei elektrischer Programmierung) bzw. fast vollständig gefertigt ist. Das ermöglicht die kostengünstige Herstellung der Bausteine durch hohe Stückzahlen, selbst wenn wenige integrierte Schaltungen je Aufgabe benötigt werden. Die Spezifizierung der Schaltung entsprechend der jeweiligen Aufgabe wird ausgehend von einer logischen Beschreibung durch Software-Werkzeuge unterstützt.

Die Umsetzung logischer Funktionen innerhalb einer Array-Struktur geschieht in Form einer kombinierten Anordnung eines UND- und eines ODER-Arrays. Vorzugsweise wird in den Arrays von WIRED-UND-, WIRED-ODER-, WIRED-NOR- oder WIRED-NAND-Verknüpfungen Gebrauch gemacht, die vorzugsweise durch den Einsatz von bipolaren Transistoren, Feldeffekttransistoren oder Dioden als Kopplungselemente in Verbindung mit PULL-UP-Elementen bzw. PULL-DOWN-Elementen in entsprechender Anordnung realisiert werden. Dabei lassen sich aufgrund der booleschen Äquivalenz durch Invertierungen die UND- oder ODER-Funktionen auch durch NAND- bzw. NOR-Funktionen darstellen.

Dabei wird durch die Aktivierung von Kopplungselementen an den Kreuzungspunkten von Leiterbahnen das logische Verhalten des Verknüpfungsfeldes festgelegt. Die logischen Verknüpfungen geschehen dann durch das Zusammenspiel der Kopplungselemente einer Leiterbahn, die deren Schaltzustand beeinflussen können.

Externe Eingänge werden in invertierter und nichtinvertierter Form einem UND-Array zugeführt, dessen Ausgangsleitungen Eingänge des ODER-Arrays sind. Ausgänge des ODER-Arrays können als externe Ausgänge, als Eingänge von aktiven Elementen und/oder als Rückführungen dienen, die fest in das UND-Array eingebracht werden. Bei den genannten aktiven Elementen handelt es sich im allgemeinen um Speicherelemente bzw. Register und Ausgangsschaltungen, deren Ausgangspolarität programmiert werden kann und die eventuell als Eingänge oder bidirektional arbeiten können. Die Anzahl der aktiven Elemente ist für jeden Typ der integrierten Logik-Arrays festgelegt. Die Funktion der Register kann gegebenenfalls programmierbar sein.

Aus der DE-A-28 26 722 ist ein Baustein der eingangs genannten Art bekannt, bei dem die zur Darstellung aller möglichen logischen Verknüpfungen erforderliche UND-Matrix und ODER-Matrix zur Platzeinsparung ineinander verschachtelt sind. Bei der Realisierung der Schaltung in Feldeffekttransistortechnologie sind die Gates der Feldeffekttransistoren der UND-Matrix in einer oberen Leiterschicht auf dem Substrat ausgebildet, während die Gates der Feldeffekttransistoren der ODER-Matrix in einer unteren Leiterschicht liegen und jeweils mit der Senke der Feldeffekttransistoren der UND-Matrix verbunden sind. Die Funktion dieses aus UND- und ODER-Matrix bestehenden Verknüpfungsfeldes unterscheidet sich nicht von der Funktion eines üblichen Verknüpfungsfeldes, bei dem UND- und ODER-Matrix räumlich nebeneinander angeordnet sind.

Mit den bisher bekannten Verknüpfungsfeldern ist es kaum oder nur in ineffektiver Weise möglich, mehrstufige Logikschaltungen innerhalb eines Verknüpfungsfeldes unterzubringen. In der Regel sind mehrere Verknüpfungsfelder und gegebenenfalls zusätzliche aktive Elemente an deren Peripherie erforderlich, um mehrstufige bzw. zusammengesetzte Logikstrukturen darzustellen. Bei Beibehaltung der Flexibilität der Anordnung, d.h. der Möglichkeit zur Darstellung möglichst vieler unterschiedlicher logischer Schaltungen innerhalb eines Verknüpfungsfeldes, kann dies zu einer großen erforderlichen Chipfläche führen. Der Bedarf an Substratfläche beeinflußt jedoch in erheblichem Maße die Herstellungskosten des Schaltungsbausteines. Der Aufbau des Chips wird außerdem unregelmäßiger und damit schlechter testbar und integrierbar.

Der Erfindung liegt die Aufgabe zugrunde, einen Baustein der eingangs genannten Art zu schaffen, der sich durch einen sehr regelmäßigen Aufbau seiner Verknüpfungsstrukturen auszeichnet und der die Realisierung mehrerer unabhängiger Logikschaltungen, gegebenenfalls deren enge Vermaschung bzw. die Ausbildung einer mehrstufigen Logikstruktur innerhalb derselben Verknüpfungsstruktur erlaubt.

Diese Aufgabe wird erfindungsgemäß durch die im Kennzeichen des Anspruchs 1 angegebenen Merkmale gelöst. Unter Vermeidung der zur Realisierung mehrstufiger Logik sonst erforderlichen Rückführungsleitungen außerhalb des Verknüpfungsfeldes besteht bei der erfindungsgemäßen Anordnung die Möglichkeit, innerhalb des Verknüpfungsfeldes selbst variable und funktional umfassende programmierbare Strukturen für die Rückführung von Signalen sowie für Übernahme von Funktionen zu schaffen, die bei herkömmlichen Schaltungen von aktiven Elementen außerhalb des Verknüpfungsfeldes ausgeführt werden. Dadurch wird eine starre Festlegung des Bausteins (z.B. Festlegung der Anzahl der Rückführungen und Register etc.) vor der endgültigen Programmierung vermieden. Das erlaubt die Verwendung der gleichen Bausteine für verschiedene Anwendungsgebiete, so daß die Bausteine in größerer Stückzahl und damit zu geringeren Kosten hergestellt werden können.

Im folgenden beziehen sich die Ausdrücke Verbindung, Verbindungsstelle und Verbindungselement stets auf eine Verbindung zwischen zwei oder mehreren Verknüpfungsmatrizen, während sich die Ausdrücke Kopplungsstelle oder Kopplungselement auf eine Kopplung zweier Leiterbahnen innerhalb einer Verknüpfungsmatrize beziehen.

Sowohl die Kopplungselemente als auch die Verbindungselemente und die weiter unten noch angesprochenen Nahtstellen sind vorzugsweise programmierbar. Das bedeutet, daß jeweils ein Element existiert, das auf eine bekannte elektrische, optische oder andere Art programmiert werden kann und das dadurch entweder selbst in einen aktivierten oder deaktivierten Zustand gebracht wird oder das auf das eigentliche die gewünschte Funktion ausübende Element aktivierend bzw. deaktivierend wirkt. Letzteres ist insbesondere bei Kopplungselementen der Fall. Die Programmierarten und ihre Wirkungsweise sind hinlänglich bekannt und brauchen deshalb hier nicht erläutert zu werden. Selbst bei einer Personalisierung des erfindungsgemäßen Bausteins durch Aufbringen einer geeigneten Metallisierung kann die erfindungsgemäße Anordnung als Modell benutzt werden, um die Umsetzung einer Schaltungsbeschreibung in einen integrierten Baustein durch Softwarewerkzeuge zu vereinfachen.

Bei der erfindungsgemäßen Lösung werden neue Verknüpfungsmöglichkeiten geschaffen und/oder Redundanzen gegenüber herkömmlichen Strukturen verringert, da nun die Möglichkeit besteht, voneinander unabhängige logische Schaltungen gleichsam in verschiedenen logischen Ebenen zu realisieren. Denn durch die Verbindungsstellen zwischen den einzelnen separaten Verknüpfungsmatrizen entsteht aus einem herkömmlichen zweidimensionalen physikalischen Verknüpfungsfeld gleichsam eine mehrdimensionale logische Verknüpfungsstruktur mit im funktionalen Sinne mehreren logischen Verknüpfungsebenen.

Die einzelnen Verknüpfungsmatrizen können dabei derart ineinander geschachtelt werden, daß die zeilenförmigen Leiterbahnen aller Verknüpfungsmatrizen in einer ersten Verdrahtungsebene und die spaltenförmigen Leiterbahnen aller Verknüpfungsmatrizen in einer über- oder unterhalb der ersten Verdrahtungsebene liegenden und gegenüber dieser isolierten zweiten Verdrahtungsebene ausgebildet sind. Die einzelnen Verknüpfungsmatrizen entstehen dann dadurch, daß die einer Verknüpfungsmatrix zugeordneten Kopplungselemente beispielsweise jede zweite spalten- und zeilenförmige Leiterbahn miteinander koppeln und damit logische Verknüpfungen der oben angesprochenen Art in dieser Leiterbahnmatrix ermöglichen. Die dazwischen liegenden Leiterbahnen werden in gleicher Weise gekoppelt. Dabei kann jede Verknüpfungsmatrix einen beliebigen herkömmlichen Array-Aufbau aufweisen. Auf die gleiche Weise lassen sich drei und mehr Verknüpfungsmatrizen innerhalb eines Verknüpfungsfeldes bilden, indem die Zuordnung der Kopplungselemente beispielsweise zu jeder dritten, vierten usw. Leiterbahn erfolgt.

Die Zuordnung der Leiterbahnen zu den einzelnen Verknüpfungsmatrizen muß nicht in der vorstehend beschriebenen regelmäßigen Weise erfolgen. Die Leiterbahnen können auch in unregelmäßiger Folge den einzelnen Verknüpfungsmatrizen zugeordnet werden, indem die Kopplungselemente an den entsprechenden Kreuzungspunkten von Leiterbahnen vorgesehen werden.

Die einzelnen logischen Verknüpfungsebenen können innerhalb des globalen physikalischen Verknüpfungsfeldes unterschiedliche Größe haben, indem den einzelnen logischen Verknüpfungsebenen verschieden viele Leitungen in Spalten- und/oder Zeilenrichtung zugeordnet werden.

Bei einer erfindungsgemäßen Realisierung können nicht nur wie bei herkömmlichen Logik-Arrays externe Eingänge mit einer einzigen, sondern auch mit einigen oder allen Verknüpfungsebenen verbunden sein, d.h. sie können in invertierter und/oder nichtinvertierter Form Kopplungselemente einer, einiger oder aller Verknüpfungsmatrizen ansteuern. Die Einwirkung auf alle Verknüpfungsebenen ist nicht immer sinnvoll, wenn z.B. eine oder mehrere logische Verknüpfungsebenen ausschließlich die Aufgabe haben, komplexe Rückkopplungen oder Kopplungen anderer Verknüpfungsebenen vorzunehmen.

Ebenso wie bei herkömmlichen Logik-Arrays können ferner separate aktive Elemente wie z. B. Register mit dem Verknüpfungsfeld verbunden werden. Bei der erfindungsgemäßen Anordnung können diese aktiven Elemente nicht nur auf eine Verknüpfungsebene wirken, d.h. auf die gleiche Verknüpfungsebene, mit der die Eingänge verbunden sind. Vielmehr lassen sie sich sinnvoll auch zu Kopplungszwecken einsetzen, indem die Ausgänge der aktiven Elemente mit anderen Verknüpfungsmatrizen verbunden sind bzw. auf andere Verknüpfungsebenen wirken, als auf die, mit denen die Eingänge der aktiven Elemente verbunden sind. Somit ist es denkbar, daß Eingänge und/oder Ausgänge eines aktiven Elementes nur je einer oder aber gemischt mehreren Verknüpfungsebenen zugeordnet sind.

Externe Ausgänge können ebenfalls auf verschiedene Weise angesteuert werden. Zum einen kann eine eigene Verknüpfungsebene dazu dienen, aus den Signalen einer oder mehrerer anderer Verknüpfungsebenen die Ausgangssignale zu bilden. Zum anderen können aktive Elemente außerhalb des Verknüpfungsfeldes aus Signalen mehrerer oder eines Verknüpfungsfeldes die Ausgangssignale bilden. Weiterhin besteht die Möglichkeit, bestimmte feste Stellen oder Leiterbahnen innerhalb des Verknüpfungsfeldes für die Steuerung der Ausgänge vorzusehen. Die Komplexität der ausführbaren Funktionen wird im allgemeinen durch die Verwendung von WIRED-Verknüpfungsfunktionen noch erhöht.

Die Flexibilität der erfindungsgemäßen Anordnung läßt sich weiter steigern, wenn freie Leiterbahnen eingefügt werden, die dadurch definiert sind, daß sie zum einen nicht externen Eingängen, aktiven Elementen oder externen Ausgängen fest zugeordnet sind und zum anderen keine Koppelelemente oder nur eine sehr kleine Anzahl derselben aufweisen, dafür aber eine überdurchschnittliche Anzahl von Verbindungselementen zwischen mehreren Verknüpfungsebenen enthalten. Dadurch, daß keine oder nur sehr wenige Kopplungselemente vorhanden sind, erreicht man, daß die freien Leiterbahnen keiner Verknüpfungsebene fest zugeordnet sind und daß der Aufwand an Programmierstellen und folglich auch Programmiereinrichtungen und -leiterbahnen reduziert wird, womit sich auch der Bedarf an Substratfläche vermindert. Diese freien Leitungen sind daher geeignet, auf wirksame Weise Verbindungen logischer Verknüpfungsebenen und entfernter Punkte innerhalb der mehrdimensionalen Verknüpfungsstruktur auch für Funktionen hoher Komplexität zu realisieren, ohne daß Redundanzen verursacht werden.

Man hat mit der erfindungsgemäßen Anordnung also nun die Möglichkeit, auch komplexe logische Schaltungen auf engstem Raum zu realisieren, indem bestimmte Teile der gesamten logischen Schaltung in verschiedenen logischen Verknüpfungsebenen dargestellt und durch eine Verbindung der logischen Verknüpfungsebenen untereinander und gegebenenfalls über separate aktive Elemente miteinander verknüpft werden. Durch die Verbindungsstellen zwischen den einzelnen Verknüpfungsmatrizen ist ein unmittelbarer Zugriff auf innere Teile der anderen Verknüpfungsebenen und damit eine sehr enge Vermaschung möglich. Rückführungen brauchen nicht mehr über eigene Rückführungsleitungen innerhalb oder außerhalb einer Verknüpfungsmatrix durchgeführt zu werden, sondern können über eine andere Verknüpfungsebene der mehrdimensionalen Verknüpfungsstruktur erfolgen. Solche Rückkopplungen können funktional beliebig komplex sein.

Die Verbindung zwischen den einzelnen Verknüpfungsmatrizen bzw. -ebenen kann über invertierende oder nicht invertierende Verbindungselemente erfolgen, wobei Verbindungen zwischen je zwei und/oder jeweils mehreren Verknüpfungsmatrizen möglich sind. Letzteres ermöglicht sehr komplexe Verknüpfungen. Der Bedarf und die Art der Verbindungselemente hängt von den Funktionen der zu verbindenden Verknüpfungsebenen ab.

Die Verbindungen können fest vorgegeben oder programmierbar sein. Auch können die Verbindungen zwischen den einzelnen logischen Verknüpfungsebenen entweder als unidirektionale Verbindungen, die gegebenenfalls auch eine Treiberfunktion haben können, ober als bidirektionale Verbindungen ausgeführt sein. Die Verbindungen können durch eigene Elemente realisiert werden, die sich an den Verbindungsstellen befinden wie z. B. Transmission-Gates, Inverter, Treiber, Transistoren, Dioden oder dergleichen. Für die Herstellung der Verbindungen können jedoch auch Kopplungselemente verwendet werden, die in diesem Falle nicht zwei Leiterbahnen einer Verknüpfungsmatrix koppeln sondern statt dessen zur Verbindung zweier oder mehrerer Verknüpfungsmatrizen dienen. Dies wird durch eine andere Anordnung eines Anschlusses dieses Kopplungselementes erreicht. Der Vorteil dieser Realisierungsform liegt darin, daß kein zusätzlicher Aufwand erforderlich ist, der eventuell den regelmäßigen Aufbau des Verknüpfungsfeldes stören könnte.

Bidirektionale fest vorgegebene nicht invertierende Verbindungen lassen sich bei der Herstellung des Bausteins am einfachsten dadurch realisieren, daß die Isolierung zwischen den beiden Verdrahtungsebenen an den Kreuzungsstellen der Leiterbahnen weggelassen wird. Diese Verbindung wirkt allerdings nicht entkoppelnd und kann Signale weder verstärken noch regenerieren.

Die Dichte und räumliche Verteilung der Verbindungsstellen zwischen verschiedenen Verknüpfungsmatrizen bzw. -ebenen kann unter Berücksichtigung der gewünschten Flexibilität der Anordnung oder einer gewissen Spezifizierung der Anordnung für bestimmte logische Schaltungen in geeigneter Weise gewählt werden. Sind die Leiterbahnen in den einzelnen Verknüpfungsmatrizen zudem noch an bestimmten Stellen oder sogar zwischen je zwei Kreuzungspunkten unterbrechbar, so können einzelne gleichsam dreidimensionale Blöcke innerhalb der mehrdimensionalen logischen Verknüpfungsstruktur gebildet werden. Durch die Programmierung kann die Größe, Anzahl und Funktion dieser Blöcke variiert werden. Dadurch lassen sich z. B. Speicherelemente beliebiger Anzahl und Funktion und fast beliebiger Lage innerhalb der mehrdimensionalen Verknüpfungsstruktur schaffen. Die dadurch entstehenden Freiheitsgrade ermöglichen eine äußerst effektive Realisierung logischer Schaltungen, da keine Bindung an eine zweidimensionale Logikstruktur mehr besteht. Dies gilt insbesondere dann, wenn die Leiterbahnen in dem betreffenden Bereich eine große Anzahl von Soll-Trenn-Stellen und Verbindungsstellen aufweisen. Auf diese Weise können innerhalb des sehr regelmäßigen Aufbaus des gesamten physikalischen Verknüpfungsfeldes neuartige Logik-Array-Strukturen erzeugt werden.

Jede zweidimensionale logische Verknüpfungsebene kann für sich betrachtet eine beliebige Struktur der oben angesprochenen Art besitzen. Innerhalb der mehrdimensionalen Verknüpfungsstruktur können die einzelnen zweidimensionalen logischen Verknüpfungsebenen wiederum gleichartig ausgebildet sein oder voneinander verschiedene Strukturen besitzen. So können das UND- und das ODER-Array eines konventionellen Logik-Arrays in jeweils einer logischen Verknüpfungsebene realisiert werden. Ebenso können auch vollständige Logik-Array-Anordnungen in mehreren logischen Verknüpfungsebenen realisiert werden, die gegebenenfalls von verschiedener Art sein können und eventuell gemischt mit einfachen UND- bzw. ODER-Verknüpfungsebenen eingesetzt werden.

Es kann auch zweckmäßig sein, die Anordnung der Kopplungselemente in zwei Verknüpfungsmatrizen derart vorzusehen, daß die Verknüpfungsmatrizen bezüglich ihrer logischen Funktion um 90° oder 180° gegeneinander gedreht sind. Dadurch ergibt sich eine komplexere Funktionalität, ohne den regelmäßigen Aufbau zu stören und die Chipfläche zu vergrößern. Dieser Vorteil macht sich insbesondere im Fall von komplexen Rückführungen bemerkbar. Dadurch erhält auch der Entwurf von Logikschaltungen mittels des erfindungsgemäßen Aufbaus gegenüber herkömmlichen Logik-Arrays einen zusätzlichen Freiheitsgrad.

Ferner können Leiterbahnsegmente einer Leiterbahn verschiedenen logischen Verknüpfungsebenen des globalen Verknüpfungsfeldes zugeteilt sein. Dadurch kann man eine enge funktional komplexe Vermaschung der logischen Verknüpfungsebenen erreichen, da statt der punktuellen Verbindung eine linienhafte Verbindung zweier oder mehrerer Verknüpfungsebenen vorgenommen werden kann. Dabei ist es denkbar, daß das verbindende Leiterbahnsegment von dem kolinear verlaufenden Rest der Leiterbahn getrennt ist. Die Verbindung erfolgt dann nur über die querlaufenden Leiterbahnen. Ist dagegen das koppelnde Leiterbahnsegment nicht abgetrennt, ergibt sich eine funktional erweiterte Verbindung, da die Wirkungsrichtung nun auch orthogonal zur Wirkungsrichtung der erstgenannten Verbindung verlaufen kann.

Weitere Merkmale der Erfindung ergeben sich aus den weiteren Unteransprüchen und der folgenden Beschreibung, welche in Verbindung mit den beigefügten Zeichnungen die Erfindung anhand von Ausführungsbeispielen erläutert. Es zeigen:

Fig. 1      eine schematische Darstellung eines Ausschnittes eines herkömmlichen Logik-Arrays und

Fig. 2 bis 4      jeweils eine schematische Draufsicht auf eine erfindungsgemäße Verknüpfungsstruktur mit zwei Verknüpfungsmatrizen.

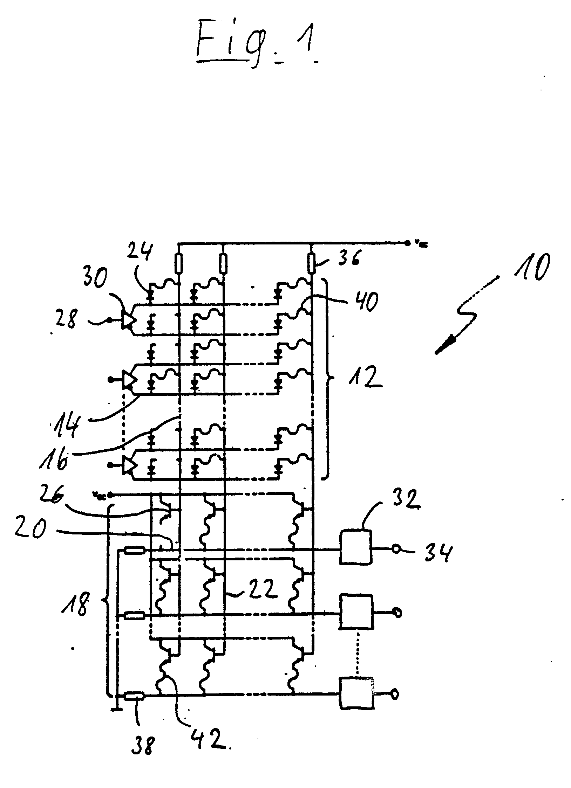

Fig. 1 zeigt ein Verknüpfungsfeld in Form eines allgemein mit 10 bezeichneten Logik-Arrays, das die Umsetzung logischer Funktionen ermöglicht. Das Logik-Array 10 umfaßt ein UND-Array 12 mit zeilenförmig angeordneten Leiterbahnen 14 und diese kreuzenden spaltenförmig angeordneten Leiterbahnen 16 sowie ein ODER-Array 18 mit zeilenförmig angeordneten Leiterbahnen 20 und spaltenförmig angeordneten Leiterbahnen 22. Die sich kreuzenden Leiterbahnen 14 und 16 des UND-Arrays 12 bzw. 20 und 22 des ODER-Arrays 18 sind durch Kopplungselemente 24 bzw. 26 miteinander gekoppelt, die beim UND-Array 12 im vorliegenden Beispiel von Dioden und im ODER-Array 18 im vorliegenden Beispiel von Transistoren gebildet sind. Bei dem zunächst hergestellten Baustein sind im vorliegenden Beispiel sämtliche Kopplungselemente aktiviert. Der Baustein wird dadurch "personalisiert", daß zur Umsetzung konkreter logischer Funktionen bestimmte Kopplungselemente 24 und/oder 26 deaktiviert werden. Dies ist im vorliegenden Beispiel durch Unterbrechung der Verbindung von Kopplungselementen 24 und 26 zu einer der gekoppelten Leiterbahnen dargestellt.

An den Eingängen 28 des UND-Arrays 12 werden den Leiterbahnen 14 über Phasensplitter 30 Eingangssignale in invertierter und nichtinvertierter Form zugeführt. Die Ausgangssignale auf den Leiterbahnen 16 des UND-Arrays 12 bilden gleichzeitig die Eingangssignale auf den Leiterbahnen 22 des ODER-Arrays 18. Die Ausgangssignale des ODER-Arrays 18 werden im vorliegenden Ausführungsbeispiel über aktive Elemente 32 externen Ausgängen 34 zugeführt. Die Leiterbahnen 16 des UND-Arrays 12 und die Leiterbahnen 20 des ODER-Arrays 18 sind über als PULL-UP-Elemente wirkende Widerstände 36 bzw. als PULL-DOWN-Elemente wirkende Widerstände 38 mit einer Betriebsspannungsquelle bzw. mit Masse verbunden.

Wie man bei dem in Fig. 1 dargestellten Beispiel erkennt, werden auf den Leiterbahnen 16 im UND-Array 12 WIRED-UND-Verknüpfungen und auf den Leiterbahnen 20 im ODER-Array 18 WIRED-ODER-Verknüpfungen ausgeführt. In diesem Sinne führen diese Leiterbahnen in Verbindung mit der Aktivierung bzw. Deaktivierung der Kopplungselemente 24 und 26 an den Programmierstellen 40 bzw. 42 die eigentlichen logischen Verknüpfungen aus.

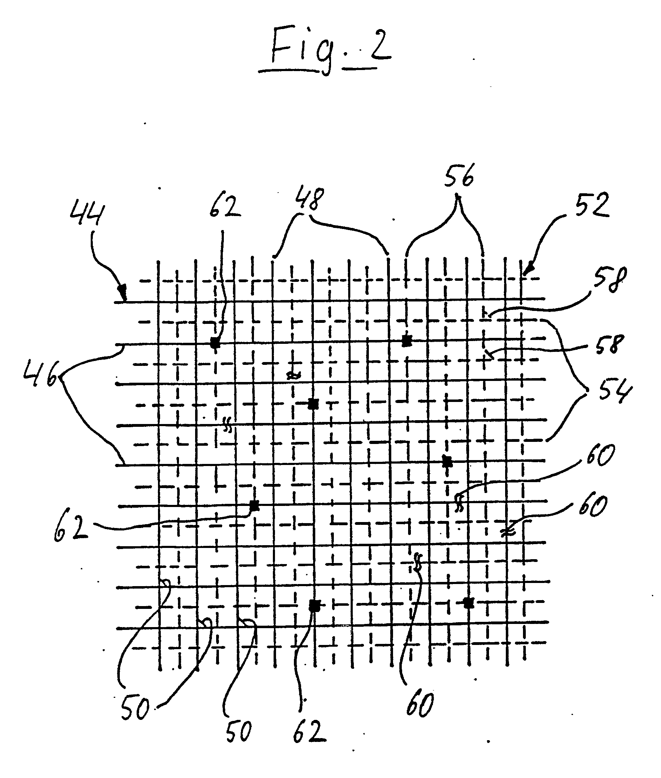

In den Fig. 2 bis 4 sind jeweils gleiche Teile mit den gleichen Bezugszeichen versehen. Die in diesen Figuren schematisch dargestellte Verknüpfungsstruktur umfaßt jeweils eine erste durch ausgezogene Linien wiedergegebene Verknüpfungsmatrix 44 mit in Zeilenrichtung verlaufenden Leiterbahnen 46 und in Spaltenrichtung verlaufenden Leiterbahnen 48. Die Leiterbahnen 46 und 48 sind durch Kopplungselemente 50 zu einer beliebigen Array-Struktur miteinander gekoppelt. Wegen des beliebigen Aufbaus der Verknüpfungsmatrix 44 wurde auf eine konkrete Darstellung aller Kopplungselemente 50 zwischen den Leiterbahnen 46 und 48 verzichtet. Sie können in der Weise ausgebildet sein, wie dies anhand der Fig. 1 erläutert wurde.

Mit der Verknüpfungsmatrix 44 ist eine durch gestrichelte Linien wiedergegebene weitere Verknüpfungsmatrix 52 verschachtelt, die in Zeilenrichtung verlaufende Leiterbahnen 54 und in Spaltenrichtung verlaufende Leiterbahnen 56 umfaßt, die ihrerseits jeweils zwischen zwei Leiterbahnen 46 bzw. 48 der Verknüpfungsmatrix 44 liegen und durch Kopplungselemente 58 miteinander gekoppelt sind. Auch hier wurde auf eine konkrete Darstellung aller Kopplungselemente verzichtet. Die Kopplungselemente 50 und 58 der Verknüpfungsmatrizen 44 bzw. 52 können so ausgeführt sein, daß die Verknüpfungsmatrizen 44 und 52 einen gleichen oder auch einen unterschiedlichen Array-Aufbau aufweisen. Beide Verknüpfungsmatrizen 44 und 52 können mit einer beliebigen Anzahl von Naht-Stellen 60 versehen sein, an denen bei Bedarf die Leiterbahnen 46, 48, 54 und 56 z. B. unterbrochen werden können.

Die beiden Verknüpfungsmatrizen 44 und 52 sind an bestimmten Kreuzungspunkten 62 ihrer Leiterbahnen 46 und 56 einerseits bzw. 48 und 54 andererseits durch Verbindungselemente verbunden oder miteinander verbindbar. Die Verbindungsstellen 62 können dabei regelmäßig über die Verknüpfungsstruktur verteilt sein oder es können bestimmte Bereiche der Verknüpfungsstruktur vordefiniert sein, in denen die Dichte der Verbindungsstellen 62 größer ist, um insbesondere bei unterbrechbaren Matrixleitungen komplexe eng vermaschte Schaltungen bzw. Schaltungselemente zu realisieren.

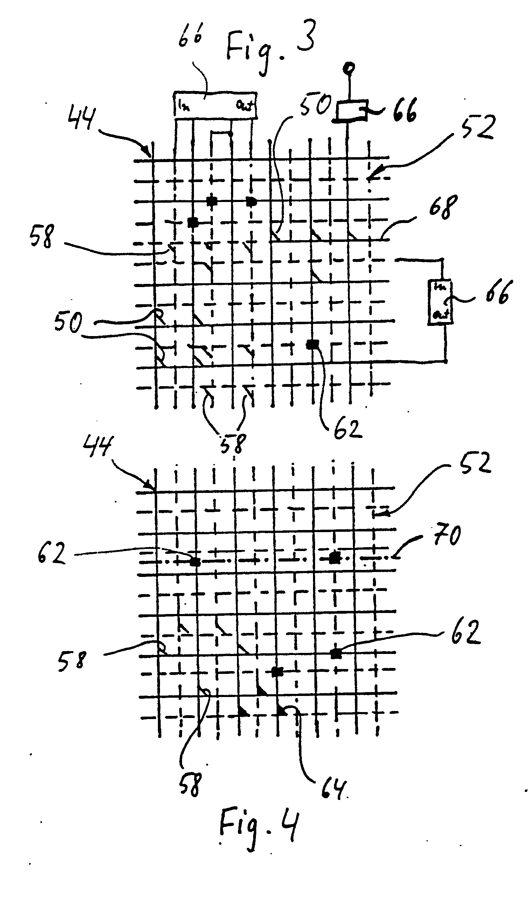

Die logische Aufteilung der erfindungsgemäßen Verknüpfungsstruktur in zwei Verknüpfungsebenen heißt nicht notwendigerweise; daß die Verknüpfungsmatrizen 44 und 52 tatsächlich in zwei voneinander getrennten Ebenen des Substrats des Bausteins angeordnet sind. Aus herstellungstechnischen Gründen ist es vielmehr vorzuziehen, daß die in Zeilenrichtung verlaufenden Leiterbahnen 46 und 54 der Verknüpfungsmatrize 44 bzw. 52 in einer ersten Verdrahtungsebene und die in Spaltenrichtung verlaufenden Leiterbahnen 48 und 56 in einer von dieser getrennten zweiten Verdrahtungsebene liegen. Dadurch, daß nur die jeweils zu einer bestimmten Verknüpfungsmatrix 44 oder 52 gehörenden Leiterbahnen 46 und 48 bzw. 54 und 56 über die schematisch angedeuteten Kopplungselemente 50 bzw. 58 miteinander koppelbar sind, entstehen zwei voneinander getrennte Verknüpfungsmatrizen, die nur an den Verbindungsstellen 62 elektrisch miteinander verbunden bzw. verbindbar sind. Die Verbindung zwischen den Verknüpfungsmatrizen kann dabei auf unterschiedliche Art und Weise erfolgen, wie dies bereits oben beschrieben wurde. In Fig. 4 ist an den Verbindungsstellen 64 angedeutet, daß hier die üblicherweise einer der beiden Verknüpfungsmatrizen 44 bzw. 52 zugeordneten Kopplungselemente zur Verbindung der beiden Verknüpfungsmatrizen 44 und 52 verwendet wurden.

Es ist leicht erkennbar, daß diese Anordnung durch jeweils mehr als eine Zwischenleitung auf mehrere Verknüpfungsebenen ausgedehnt werden kann. Prinzipiell ist dabei die Anzahl der Verknüpfungsebenen nicht begrenzt. In der Praxis dürfte es jedoch nicht zweckmäßig sein, zu viele Verknüpfungsebenen ineinander zu schachteln, weil bei sehr vielen logischen Verknüpfungsebenen bei noch vertretbarer Chipfläche und Verarbeitungsgeschwindigkeit relativ wenig Schaltungslogik innerhalb der jeweiligen Ebenen realisiert werden kann.

Aktive Elemente können in der in der Fig. 3 angedeuteten Weise am Rande des Verknüpfungsfeldes angeordnet und auf unterschiedliche Weise mit einer oder mehreren Verknüpfungsmatrizen verbunden sein, wie dies weiter oben bereits erläutert wurde. In dem in der Fig. 3 dargestellten Beispiel sind die beiden Verknüpfungsmatrizen 44 und 52 über das aktive Element 66 miteinander verbunden. Im übrigen wurde auf die detaillierte Einzeichnung von z. B. separaten Registern und externen Ein- und Ausgängen bewußt verzichtet, weil deren Anschluß an Arrays an sich bekannt ist.

In Fig. 3 ist ferner der Fall angedeutet, daß die Verknüpfungsmatrizen 44 und 52 um 180° gegeneinander verdreht sind, was durch eine entsprechende Anordnung der Kopplungselemente 58 angedeutet ist. Durch diese Änderung der Wirkungsrichtung beim Übergang von einer logischen Verknüpfungsebene zur anderen lassen sich aufeinfachste Weise komplexe Funktionen und Rückführungen darstellen.

In Fig. 3 ist ferner mit 68 eine Leiterbahn bezeichnet, deren linke gestrichelte Hälfte der Verknüpfungsmatrix 52 zugeordnet ist und deren rechte ausgezogen dargestellte Hälfte der Verknüpfungsmatrix 44 zugeordnet ist. Durch die Verwendung einzelner Segmente einer Leiterbahn für verschiedene Verknüpfungsmatrizen läßt sich eine besonders raumsparende Ausbildung logischer Schaltungen erreichen. Dabei können die Segmente der Leiterbahn voneinander getrennt oder auch miteinander verbunden sein, um eine Verbindung der Verknüpfungsmatrizen herstellen zu können, wobei die Verbindung vorzugsweise programmierbar herstellbar ist.

In Fig. 4 ist mit der strichpunktierten Linie 70 eine freie Leitung dargestellt, die nicht von vornherein einer der beiden Verknüpfungsmatrizen 44 und 52 fest zugeordnet oder mit externen Eingängen, Ausgängen und aktiven Elementen verbunden ist. Eine solche freie Leitung erhöht die Flexibilität bei der Gestaltung logischer Schaltungen. Im vorliegenden Ausführungsbeispiel in Fig. 4 ist angedeutet, daß durch die freie Leiterbahn 70 räumlich voneinander entfernt gelegene Punkte der beiden Verknüpfungsmatrizen 44 und 52 direkt miteinander verbunden werden können.

Verfügt die freie Leitung 70 auch über einige Kopplungselemente, die von ihr gesteuert den Schaltzustand anderer Leiterbahnen 46, 48, 54, 56 beeinflussen, wird deren Funktionalität insbesondere bei einem nicht ununterbrochen geradlinigen Verlauf stark erweitert.

Über die bereits oben beschriebenen Vorteile hinaus besteht bei der erfindungsgemäßen Verknüpfungsstruktur die Möglichkeit, innerhalb einer Array-Struktur nicht nur neue Schaltungsfunktionen zu realisieren, sondern beispielsweise auch den verschiedenen Verknüpfungsebenen verschiedene Funktionen zuzuordnen. Beispielsweise kann eine Ebene die Funktion von aktiven Elementen übernehmen, und zwar eventuell zusätzlich zu den am Rande des Verknüpfungsfeldes untergebrachten aktiven Elemente 66 (Fig. 3). Innerhalb der Verknüpfungsebene wird die Funktion und die Anzahl dieser aktiven Elemente programmierbar. Zudem haben diese Elemente direkteren Zugriff auf andere Verknüpfungsebenen und arbeiten deshalb effektiver. Dies bedeutet einen zusätzlichen Freiheitsgrad gegenüber herkömmlichen Arraystrukturen.

Vorteilhafte Anwendungen der erfindungsgemäßen Verknüpfungsstruktur sind auch für den Bereich der Datenverarbeitung denkbar, indem beispielsweise einzelne Verknüpfungsebenen speziell für die Bearbeitung von Bussignalen und zur Ausübung von Kontrollfunktionen ausgeprägt werden.

Eine weitere Möglichkeit zur vorteilhaften Nutzung der erfindungsgemäßen Verknüpfungsstruktur besteht beispielsweise darin, daß die Funktion einer logischen Verknüpfungsebene durch eine weitere logische Verknüpfungsebene überwacht werden kann. Beim Auftreten von Fehlern kann durch diese funktional übergeordnete Verknüpfungsebene eine weitere Verknüpfungsebene mit der Durchführung der Funktionen der fehlerhaften Verknüpfungsebene beauftragt werden.

Als Beispiel für eine weitere Art, die Vorteile der erfindungsgemäßen Gestaltung zu nutzen, soll der PLA (Programmable Logic Array)-Addierer nach Weinberger dienen (siehe A. Weinberger, "High Speed Programmable Logic Array Adders", IBM Journal of Research and Development, Vol. 23, Nr. 2, März 1979). Bei diesen PLA-Addierern werden vier Eingänge gemeinsam an speziellen Decodern decodiert, in einem Verknüpfungsfeld verknüpft und anschließend von Exklusiv-ODER-Gattern zusammengefaßt. Weil dieser Aufbau speziell auf Addierzwecke zugeschnitten ist, kann er nicht mit einem herkömmlichen Logik-Array-Baustein realisiert werden. Dagegen ist dies mit einem erfindungsgemäßen Baustein möglich. Dazu werden die Eingänge in einer ersten Verknüpfungsebene decodiert, in einer zweiten verknüpft und die Verknüpfungsergebnisse in einer dritten Ebene, welche die Exklusiv-ODER-Funktionen ausübt, zusammengefaßt und zu den Ausgängen geführt. In gleicher Weise läßt sich die Erweiterung des Prinzips auf Arithmetic Logic Units übertragen (s. M.S. Schmogler "Design of large ALUs using multiple PLA-macros", IBM Journal of Research and Development, Vol. 24, Nr. 1, Januar 1980). Anhand dieser Beispiele kann man erkennen, daß die erfindungsgemäße Gestaltung eines Logik-Array-Bausteins neue Anwendungen ermöglicht und sich damit vorteilhaft von den herkömmlichen Logik-Arrays unterscheidet.

**Patentansprüche**

1. In integrierter Technik hergestellter Logik-Array-Baustein zur Erstellung integrierter Schaltungen mit einem Substrat, auf dem mindestens ein Verknüpfungsfeld und außerhalb desselben aktive Elemente (66) ausgebildet sind, die zur Ein- und Ausgabe von Signalen und zur Funktionserweiterung des Verknüpfungsfeldes bestimmt sind, wobei dieses aus spalten- und zeilenförmig angeordneten Leiterbahnen (46, 48; 54, 56) besteht, die an ihren Kreuzungspunkten durch Kopplungselemente (50, 58) koppelbar sind, die abhängig vom logischen Schaltzustand einer Leiterbahn den logischen Schaltzustand einer diese kreuzenden Leiterbahn beeinflussen, und wobei das Verknüpfungsfeld mindestens zwei Verknüpfungsmatrizen (44, 52) umfaßt, die so ineinander geschaltet sind, daß die Zeilen (46, 54) und Spalten (48, 56) der einen Verknüpfungsmatrix (44, 52) die Spalten (56, 48) bzw. Zeilen (54, 46) der anderen Verknüpfungsmatrix (52, 44) kreuzen, wobei mindestens eine Leiterbahn einer Verknüpfungsmatrix mit mindestens einer Leiterbahn (46, 48; 54, 56) der anderen Verknüpfungsmatrix (44, 52) über ein Verbindungselement (62) verbindbar ist, dadurch **gekennzeichnet,** daß die Kopplungselemente (50, 58) des Verknüpfungsfeldes so angeordnet sind, daß voneinander unabhängige Verknüpfungsmatrizen (44, 52) gebildet sind und daß die in Zeilenrichtung verlaufenden Leiterbahnen (46, 54) aller Verknüpfungsmatrizen (44, 52) in einer ihnen gemeinsamen ersten Verdrahtungsebene und die in Spaltenrichtung verlaufenden Leiterbahnen (48, 56) aller Verknüpfungsmatrizen (44, 52) in einer ihnen gemeinsamen ober- oder unterhalb der ersten Ebene liegenden und gegenüber dieser isolierten zweiten Verdrahtungsebene liegen.

2. Baustein nach Anspruch 1 dadurch **gekennzeichnet,** daß mindestens eine Verknüpfungsmatrix (44, 52) eine von den anderen Verknüpfungsmatrizen verschiedene Array-Struktur besitzt.

3. Baustein nach einem der Ansprüche 1 und 2, dadurch **gekennzeichnet,** daß die Kopplungselemente (50, 58) innerhalb zweier Verknüpfungsmatrizen (44, 52) derart angeordnet sind, daß die Verknüpfungsmatrizen (44, 52) bezüglich ihrer logischen Funktion gegeneinander gedreht sind.

4. Baustein nach einem der Ansprüche 1 bis 3, dadurch **gekennzeichnet,** daß die Verknüpfungsmatrizen (44, 52) unterschiedlichen Umfang besitzen.

5. Baustein nach einem der Ansprüche 1 bis 4, dadurch **gekennzeichnet,** daß mindestens eine Verknüpfungsmatrix (44, 52) einen vollständigen Logik-Array-Aufbau mit einer eine UND-Funktion und einer eine ODER-Funktion ausübenden Teilmatrix aufweist.

6. Baustein nach einem der Ansprüche 1 bis 5, dadurch **gekennzeichnet,** daß mindestens ein Verbindungselement (62) derart ausgebildet ist, daß es Leiterbahnen (46, 48; 54, 56) von zwei oder mehreren Verknüpfungsmatrizen (44, 52) miteinander verbindet.

7. Baustein nach einem der Ansprüche 1 bis 6, dadurch **gekennzeichnet,** daß mindestens eine Leiterbahn (68) segmentweise mindestens zwei verschiedenen Verknüpfungsmatrizen (44, 52) zugeordnet ist, wobei die Leiterbahnsegmente voneinander getrennt, fest miteinander verbunden oder mit einer programmierbar ein- bzw. ausschaltbaren Übergangsstelle versehen sind.

8. Baustein nach einem der Ansprüche 1 bis 7, dadurch **gekennzeichnet,** daß mindestens eine Verbindungsstelle (62) zwischen den Verknüpfungsmatrizen (44, 52) ein programmierbar einschaltbares oder ausschaltbares Verbindungselement oder bei unidirektionalen Verbindungselementen ein in der Übertragungsrichtung umschaltbares Verbindungselement umfaßt.

9. Baustein nach einem der Ansprüche 1 bis 8, dadurch **gekennzeichnet,** daß das Verbindungselement als signalregenerierendes Verbindungselement ausgebildet ist.

10. Baustein nach einem der Ansprüche 1 bis 9, dadurch **gekennzeichnet,** daß der Eingang oder die Eingänge und/oder ein Ausgang bzw. mehrere Ausgänge mindestens eines aktiven Elementes mit Leiterbahnen mehrer Verknüpfungsmatrizen (44, 52) verbunden sind.

11. Baustein nach einem der Ansprüche 1 bis 10, dadurch **gekennzeichnet,** daß alle Ausgänge des Verknüpfungsfeldes mit einer einzigen Verknüpfungsmatrix (44) bzw. (52) verbunden sind.

12. Baustein nach einem der Ansprüche 1 bis 11, dadurch **gekennzeichnet,** daß das Verknüpfungsfeld mindestens eine freie Leiterbahn (70) umfaßt, die weder einem externen Eingang, noch einem aktiven Element noch einem externen Ausgang zugeordnet ist und die mit mindestens zwei anderen Leiterbahnen (48, 56) durch Verbindungselemente (62) verbunden ist.

13. Baustein nach Anspruch 12, dadurch **gekennzeichnet,** daß mindestens eine freie Leiterbahn (70) mit einer im Vergleich zu den übrigen Leiterbahnen sehr geringen Anzahl von Kopplungselementen so gekoppelt ist, daß diese von der freien Leiterbahn (70) gesteuert auf kreuzende Leiterbahnen (48, 56) verknüpfend wirken.

14. Baustein nach einem der Ansprüche 1 bis 13, dadurch **gekennzeichnet,** daß mindestens eine Leiterbahn (46, 48; 54, 56) mindestens einer Verknüpfungsmatrix (44, 52) eine Naht-Stelle (60) aufweist, die programmierbar von einem verbindenden in einen unterbrechenden oder von einem unterbrechenden in einen verbindenden Zustand bringbar ist.

15. Baustein nach Anspruch 14, dadurch **gekennzeichnet,** daß die Dichte der Naht-Stellen (60) und/oder die Dichte der Verbindungsstellen (62) in dem Verknüpfungsfeld inhomogen ist.

## Claims

1. Logic array unit, produced by integration techniques, for the preparation of integrated circuits, having a substrate on which are formed at least one connection field and active elements (66) outside the latter, which are intended for the input and output of signals and to extend the functions of the connection field, the latter consisting of conductor tracks (46, 48; 54, 56), arranged in the form of columns and lines, which can be coupled at their crossing points by means of coupling elements (50,58) which, depending on the logic switched status of a conductor track influence the logic switched status of a conductor track crossing the latter, and the connection field comprising at least two connection matrices (44,52) which are connected into one another in such a way that the lines (46, 54) and columns (48,56) of one connection matrix (44,52) cross the columns (56,48) and lines (54,46) respectively of the other connection matrix (52,44), at least one conductor track of one connection matrix being able to be connected to at least one conductor track (46,48; 54,56) of the other connection matrix (44,52) by way of a connecting element (62), characterised in that the coupling elements (50,58) of the connection field are so arranged that connection matrices (44,52) independent of each other are formed and that the conductor tracks (46,54), running in the line direction, of all connection matrices (44,52) lie in a first wiring plane common to them and the conductor tracks (48, 56), running in the column direction, of all connection matrices (44,52) lie in a second wiring plane common to them, situated above or below the first plane and insulated with respect to the latter.

2. Unit according to Claim 1, characterised in that at least one connection matrix (44,52) has a different array structure from the other connection matrices.

3. Unit according to either of Claims 1 and 2, characterised in that the coupling elements (50,58) are so arranged within two connection matrices (44,52) that the connection matrices (44,52) are rotated with respect to each other with regard to their logic function.

4. Unit according to one of Claims 1 to 3, characterised in that the connection matrices (44,52) have a different extent.

5. Unit according to one of Claims 1 to 4, characterised in that at least one connection matrix (44,52) has a complete logic array structure with a part matrix performing an AND-function and a part matrix performing an OR-function.

6. Unit according to one of Claims 1 to 5, characterised in that at least one connecting element (62) is so constructed that it connects conductor tracks (46,48; 54,56) of two or more connection matrices (44,52) to one another.

7. Unit according to one of Claims 1 to 6, characterised in that at least one conductor track (68) is associated, in segments, with at least two different connection matrices (44,52), the conductor track segments being separated from one another, rigidly connected to one another, or provided with a transition point that can be programmably switched in and/or out.

8. Unit according to one of Claims 1 to 7, characterised in that at least one connecting point (62) between the connection matrices (44,52) comprises a connecting element that can be programmably switched in or out or, in the case of unidirectional connecting elements, a connecting element that can be switched over in the transmission direction.

9. Unit according to one of Claims 1 to 8, characterised in that the connecting element is in the form of a signal-regenerating connecting element.

10. Unit according to one of Claims 1 to 9, characterised in that the input or inputs and/or one or more outputs of at least one active element are connected to conductor tracks of several connection matrices (44,52).

11. Unit according to one of Claims 1 to 10, characterised in that all outputs of the connection field are connected to a single connection matrix (44) or (52).

12. Unit according to one of Claims 1 to 11, characterised in that the connection field comprises at least one free conductor track (70) which is associated neither with an external input, nor an active element, nor an external output, and which is connected by means of connecting elements (62) to at least two other conductor tracks (48,56).

13. Unit according to Claim 12, characterised in that at least one free conductor track (70) is so coupled to a number, very small in comparison with the remaining conductor tracks, of coupling elements that the latter, controlled by the free conductor track (70), have a connective effect on crossing conductor tracks (48,56).

14. Unit according to one of Claims 1 to 13, characterised in that at least one conductor track (46,48; 54,56) of at least one connection matrix (44,52) has an interface (60) which can be programmably brought from a connecting into an interrupting or from an interrupting into a connecting status.

15. Unit according to Claim 14, characterised in that the density of the interfaces (60) and/or the density of the connecting points (62) in the connection field is unhomogeneous.

## Revendications

1. Elément de réseau logique fabriqué en technologie intégrée pour la construction de circuits intégrés avec un substrat, sur lequel sont formés au moins une zone logique et des éléments actifs (66) à l'extérieur de celle-ci, qui sont prévus pour l'entrée et la sortie de signaux et pour une extension fonctionnelle de la zone logique, celle-ci se composant de bandes conductrices (46,48 ; 54,56) disposées en colonnes et lignes, qui peuvent être couplées en leurs points d'intersection par des éléments de couplage (50,58), qui influent sur l'état logique d'une de ces bandes conductrices croisées en dépendance de l'état logique d'une bande conductrice, la zone logique comportant au moins deux matrices logiques (44,52), qui sont mutuellement agencées de telle sorte que les lignes (46,54) et les colonnes (48,56) de l'une des matrices (44, 52) croisent les colonnes (56,48) respectivement les lignes (54,46) de l'autre matrice, au moins une bande conductrice d'une matrice logique pouvant être reliée avec au moins une bande conductrice (46,48 ; 54,56) de l'autre matrice (44,52) par un élément de liaison (62), caractérisé en ce que les éléments de couplage (50,58) de la zone logique sont agencés de telle sorte que sont formées des matrices logiques (44,52) indépendantes l'une de l'autre et en ce que les bandes conductrices (46,54), s'étendant dans la direction de lignes, de toutes les matrices logiques (44,52), sont situées dans un premier plan de câblage commun à celles-ci et que les bandes conductrices (48,56), s'étendant dans la direction de colonnes, de toutes les matrices logiques (44,52) sont situées dans un deuxième plan de câblage commun à celles-ci situé au-dessous ou en dessous du premier plan et isolé de celui-ci.

2. Elément selon la revendication 1, caractérisé en ce qu'au moins une matrice logique (44,52) possède une structure-réseau différente des autres matrices logiques.

3. Elément selon l'une des revendications 1 et 2, caractérisé en ce que les éléments de couplage (50,58) sont agencés à l'intérieur de deux matrices logiques (44,52), de telle sorte que les matrices logiques (44,52) sont opposées en ce qui concerne leur fonction logique.

4. Elément selon l'une des revendications 1 à 3, caractérisé en ce que les matrices logiques (44,52) possèdent des étendues différentes.

5. Elément selon l'une des revendications 1 à 4, caractérisé en ce qu'au moins une matrice logique (44,52) présente une totale constitution de réseau logique avec une matrice partielle exerçant une fonction ET et une matrice partielle exerçant une fonction OU.

6. Elément selon l'une des revendications 1 à 5, caractérisé en ce qu'au moins un élément de liaison (62) est formé de telle sorte qu'il relie ensemble des bandes conductrices (46,48 ; 54,56) de deux ou de plusieurs matrices logiques (44,52).

7. Elément selon l'une des revendications 1 à 6, caractérisé en ce qu'au moins une bande conductrice (68) est affectée par segments à au moins deux matrices logiques différentes (44,52), les segments de la bande conductrice étant séparés l'un de l'autre, liés solidairement l'un à l'autre ou munis d'une transition pouvant être connectée, respectivement déconnectée, de façon programmable.

8. Elément selon l'une des revendications 1 à 7, caractérisé en ce qu'au moins un emplacement de liaison (62) entre les matrices logiques (44,52) comporte un élément de liaison connectable ou déconnectable de façon programmable ou pour les éléments de liaison unidirectionnels, un élément de liaison réversible dans la direction de transfert.

9. Elément selon l'une des revendications 1 à 8, caractérisé en ce que l'élément de liaison est formé comme un élément de liaison régénérant le signal.

10. Elément selon l'une des revendications 1 à 9, caractérisé en ce que l'entrée ou les entrées et/ou une sortie, respectivement plusieurs sorties, d'au moins un élément actif sont liées avec les bandes conductrices de plusieurs matrices logiques (44,52).

11. Elément selon l'une des revendications 1 à 10, caractérisé en ce que toutes les sorties de la zone logique sont reliées avec une seule matrice logique (44) respectivement (52).

12. Elément selon l'une des revendications 1 à 11, caractérisé en ce que la zone logique comporte au moins une bande conductrice libre (70), qui n'est affectée ni à une entrée externe, ni à un élément actif, ni à une sortie externe et qui est reliée avec au moins deux autres bandes conductrices (48,56) à travers les éléments de liaison (62).

13. Elément selon la revendication 12, caractérisé en ce qu'au moins une bande conductrice libre (70) est couplée avec un très petit nombre, en comparaison du reste des bandes conductrices, d'éléments de couplage de telle sorte que ceux-ci agissent combinatoirement, commandés par la bande conductrice libre (70) sur des bandes conductrices croisées (48,56).

14. Elément selon l'une des revendications 1 à 13, caractérisé en ce qu'au moins une bande conductrice (46,48 ; 54,56) d'au moins une matrice logique (44,52) possède une jonction (60) qui peut être amenée de façon programmable depuis un état de liaison dans un état d'interruption ou d'un état d'interruption dans un état de liaison.

15. Elément selon la revendication 14, caractérisé en ce que l'épaisseur des jonctions (60) et/ou l'épaisseur des emplacements de liaison (62) est inhomogène dans la zone logique.

Fig. 1

# Fig. 2

Fig. 3

Fig. 4